# FASCICULE DE BREVET EUROPEEN

(11) **EP 3 595 007 B1**
(45) Date de publication et mention de la délivrance du brevet: **30.12.2020**
(21) Numéro de dépôt: 19184339.0
(22) Date de dépôt: 04.07.2019
(51) Int. Cl.: H01L 33/62, H01L 25/075, H01L 25/00, H01L 23/00, H01L 51/56, H01L 21/683, H01L 51/00

(54) **PROCÉDÉ DE TRANSFERT DE STRUCTURES**
VERFAHREN ZUR ÜBERTRAGUNG VON STRUKTUREN
METHOD OF TRANSFERRING STRUCTURES

(30) Priorité: 10.07.2018 FR 1856356
(43) Date de publication de la demande: 15.01.2020
(73) Titulaire: Commissariat à l'énergie atomique et aux énergies alternatives, 75015 Paris (FR)
(72) Inventeur: BENAISSA, Lamine, 38054 Grenoble Cedex 09 (FR); DEGIRMENCIOGLU, Ismail, 38054 Grenoble Cedex 09 (FR)
(74) Mandataire: Brevalex

(56) Documents cités:
- US-A1- 2016 043 254
- US-A1- 2016 111 604

## Description

### DOMAINE TECHNIQUE

La présente invention concerne un procédé de report de structures sur une face d'accueil d'un substrat d'accueil. Notamment, la présente invention met en œuvre une couche support pourvue de régions pliables et dépliables permettant de faire varier l'espacement entre les structures.

### ÉTAT DE LA TECHNIQUE ANTÉRIEURE

Un procédé de transfert de structures connu de l'état technique est décrit dans le document [1] cité à la fin de la description et illustré aux figures la à 1c.

Le procédé connu de l'état de la technique comprend notamment les étapes successives suivantes :
a) la fourniture d'un substrat temporaire 1 comprenant deux faces principales, essentiellement parallèles, dites respectivement première la et seconde 1b face, le substrat temporaire 1 étant étirable, une pluralité de structures 2 étant assemblées selon une de leur face, dite face avant, sur la première face ;
b) étirer le substrat temporaire 1 selon au moins une direction de manière à augmenter l'espacement selon l'au moins une direction entre les structures,
c) une étape de report de la pluralité de structures sur une face d'accueil 4a d'un substrat final 4.

L'étape a) est généralement précédée d'une étape de prélèvement de la pluralité de structures qui reposent par une de leur face, opposée à la face avant, dite face arrière, sur une face, dite face initiale, d'un substrat initial 3.

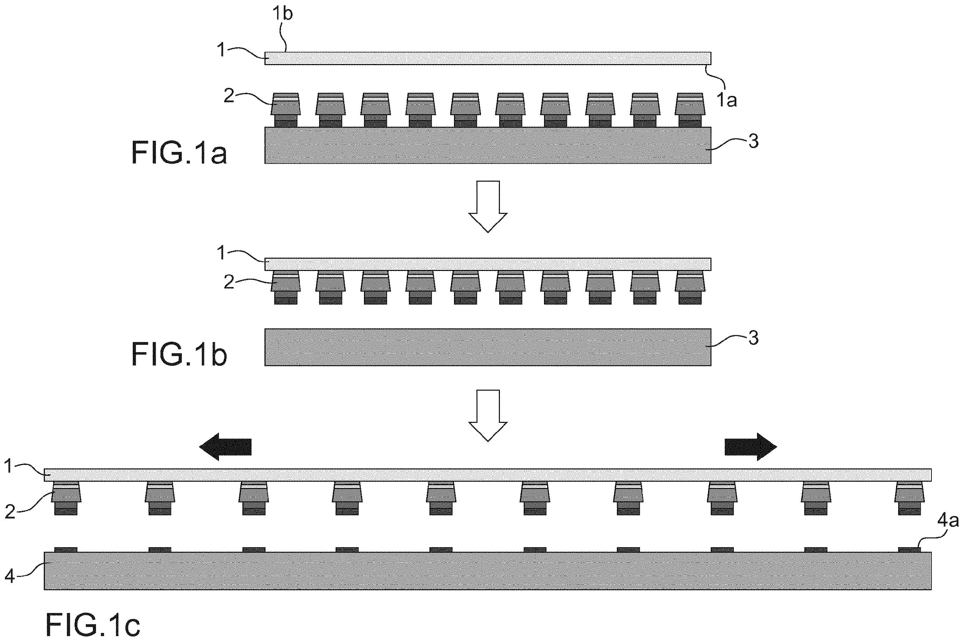

En particulier, l'étape de prélèvement (figure 1a) peut comprendre l'assemblage de la première face la du substrat temporaire avec la face avant de chacune des structures, suivie du détachement desdites structures de la face initiale (figure 1b).

À cet égard, l'adhésion entre la face arrière et la face initiale est généralement ajustée pour faciliter l'étape de prélèvement.

Notamment, l'adhésion entre la face arrière et la face initiale peut présenter une énergie inférieure à l'énergie d'adhésion des structures sur la première face du substrat temporaire, de sorte que le détachement s'effectue de manière sélective entre la face initiale du substrat initial et la face arrière des structures.

Le substrat temporaire proposé dans [1] est un substrat étirable. En d'autres termes, le substrat temporaire est fait d'un matériau dont le module Young est suffisamment faible pour étirer ledit substrat temporaire selon au moins une direction, dite direction d'étirement. Le matériau, selon [1], peut notamment comprendre un matériau polymère flexible, et en particulier un élastomère.

Par « élastomère », on entend un polymère qui présente des propriétés élastiques et est susceptible, sous l'effet d'une traction ou d'un étirement, de présenter une forte déformation avant rupture. Plus particulièrement, la mesure de l'élasticité d'un matériau est quantifiée par son module d'Young, et un matériau sera considéré comme étirable dès lors que son module d'Young est inférieur à 0,1 GPa.

L'étape b) du procédé connu de l'état de la technique comprend l'application d'une force de traction au substrat temporaire selon au moins une direction, comprise dans le plan formé par la première face, de manière à étirer ledit substrat (figure 1c). De cet étirement résulte une augmentation de l'espacement entre les structures avant leur report sur la face d'accueil du substrat d'accueil.

Ce procédé est alors mis en œuvre dès lors qu'il s'agit de transférer des structures selon un agencement ou espacement différent entre lesdites structures d'un substrat à l'autre, venant ainsi palier les problèmes de coûts et de temps de cycle associés au transfert de structures par placement individuel (« Pick and Place » selon la terminologie anglo-saxonne).

Cependant, ce procédé de transfert massif de structures n'est pas non plus satisfaisant.

En effet, l'étirement, à l'étape b), du substrat temporaire n'est pas uniforme. Notamment les zones de contact entre les structures et la face temporaire ne sont pas soumises à la même amplitude d'étirement que le reste du substrat temporaire.

Cette non uniformité d'étirement affecte, et notamment réduit, l'adhésion des structures sur la face temporaire. L'amplitude d'étirement est donc limitée de manière à garantir l'adhésion des structures sur la surface temporaire.

Par ailleurs, l'étirement impose également une contrainte au niveau des structures, et peut ainsi provoquer une déformation de ces dernières.

En outre, l'efficacité du prélèvement des structures sur le substrat initial est, en partie, régie par l'énergie d'adhésion des structures au matériau formant le substrat temporaire, et une sélectivité de prélèvement ne peut être assurée pour tous les matériaux étirables.

Enfin, l'étirement ne permet que des réagencements homothétiques des structures, offrant ainsi bien peu de flexibilité en termes de réagencement des structures lors de l'étape de report.

Un autre procédé de transfert de structures comprenant une couche support avec des régions de pliage est décrit dans le document [4] cité à la fin de la description.

Un but de la présente invention est donc de proposer un procédé de transfert collectif, de structures via une couche support permettant des variations d'espacements entre les structures bien supérieures à celles connus de l'état de la technique.

Un autre but de la présente invention est de proposer un procédé de transfert, massif, de structures via une couche support offrant plus de degrés de liberté en termes de repositionnement des structures que les procédés connus de l'état de la technique.

### EXPOSÉ DE L'INVENTION

Les buts de la présente invention sont, au moins en partie, atteints par un procédé de transfert de structures sur un substrat d'accueil, le procédé comprenant les étapes successives suivantes :
a) fournir une couche support comprenant deux faces principales dites, respectivement, première face et seconde face, des structures, comprenant chacune une face avant et une face arrière, étant assemblées par leur face avant sur la première face ;
c) une étape de report des structures sur une face d'accueil d'un substrat d'accueil,
le procédé étant remarquable en ce que la couche support comprend des régions de pliage, entre les structures, adaptées pour passer, de manière réversible, d'un état plié à un état déplié sous l'action d'une excitation extérieure, le procédé comprend en outre, entre les étapes a) et c), une étape b) d'exécution de l'action extérieure de manière à faire passer les régions de pliage de l'un ou l'autre des états plié ou déplié à l'autre des états plié ou déplié de sorte que l'espacement entre les positions relatives des structures les unes par rapport aux autres varie avant l'exécution de l'étape c).

Selon la présente invention, a couche support comprend une couche intermédiaire adaptée pour, sous l'action de l'excitation extérieure, faire varier son état de contrainte, et ainsi générer le passage de l'un ou l'autre des états plié et déplié à l'autre de ces deux états.

Selon la présente invention, a couche support comprend de sa première face vers sa seconde face, une première couche, la couche intermédiaire, et une seconde couche, la première couche et la seconde couche, présentant, respectivement, des premières tranchées et des secondes tranchées au niveau desquelles s'inscrivent des plis au niveau des régions de pliage lorsque la couche support est dans l'état plié.

Selon un mode de mise en œuvre, lors du passage d'un état déplié à un état plié, le changement d'état de contrainte de la couche intermédiaire correspond à un gonflement de ladite couche de sorte que les premières tranchées et les secondes tranchées définissent sur la première face, dans l'état plié, respectivement, des plis en arrête et des plis en creux.

Selon un mode de mise en œuvre, lors du passage d'un état déplié à un état plié, le changement d'état de contrainte de la couche intermédiaire correspond à une contraction de ladite couche de sorte que les premières tranchées et les secondes tranchées définissent sur la première face, dans l'état plié, respectivement, des plis en creux et des plis en arrête.

Selon un mode de mise en œuvre, la première couche et la seconde couche présentent chacune un module d'Young supérieur à celui de la couche intermédiaire, avantageusement le module d'Young de la première couche et de la seconde couche est supérieur à 2 GPa, encore plus avantageusement égal à 4 GPa.

Selon un mode de mise en œuvre, la première couche et la seconde couche comprennent du poly(p-methylstyrène).

Selon un mode de mise en œuvre, l'excitation extérieure est une variation de pH.

Selon un mode de mise en œuvre, la couche intermédiaire comprend au moins un des éléments choisi parmi : Poly(4-vinyl pyridine)-polystryrène, Poly(2-hydroxyethyl methacrylate)-poly(acide methacrylique), Poly(acide methacrylique)-polyethylène glycol, Poly(N-isopropylacrylamide-co-acide acrylique)-polyethylène glycol), Poly(chlorure de methacryloxyethyl trimethylammonium)-or.

Selon un mode de mise en œuvre, l'excitation extérieure comprend l'adjonction d'un solvant, notamment de l'eau ou du méthanol.

Selon un mode de mise en œuvre, la couche intermédiaire comprend au moins un des éléments choisi parmi : alcool polyvinylique- chitosane, chitosane polyéthylène glycol, polydiméthylsiloxane-polyurethane/2--hydroxyéthyl méthacrylate, poly(glycidyl méthacrylate)-or.

Selon un mode de mise en œuvre, l'excitation extérieure comprend une variation de température, notamment une élévation de température.

Selon un mode de mise en œuvre, la couche intermédiaire comprend au moins un des éléments choisi parmi : polydiméthylsiloxane-or, résine SU8-polycaprolactone, poly(N-isopropylacrylamide)-polycaprolactone, polycaprolactone, poly(caprolactone-co-pentadecadolactone).

Selon un mode de mise en œuvre, l'excitation extérieure comprend une impulsion électrique, la couche intermédiaire comprenant avantageusement du polydiméthylsiloxane-cardiomyocytes ou du poly pyrrole-or.

Selon un mode de mise en œuvre, l'excitation extérieure comprend la mise œuvre d'un enzyme, la couche intermédiaire comprenant avantageusement du métal-gélatine-carboxyméthylcellulose.

Selon un mode de mise en œuvre, la couche support repose par sa seconde face sur un substrat support, l'énergie d'adhésion entre la seconde face et le substrat support étant ajustée afin de permettre le passage de l'un ou l'autre des états plié et déplié à l'autre de ces deux états, avantageusement, l'énergie d'adhésion est inférieure à 0,5 J/m², encore plus avantageusement inférieure à 0,3 J/m².

Selon un mode de mise en œuvre, une couche, dite couche de relâchement, est intercalée entre la couche support et le substrat support, avantageusement la couche de relâchement comprend un acide polyacrylique.

Selon un mode de mise en œuvre, l'étape a) est précédée d'une étape de prélèvement a1) des structures disposées selon leur face arrière, sur une face, dite face initiale, d'un substrat initial.

Selon un mode de mise en œuvre, l'étape de prélèvement a1) comprend successivement :
- un assemblage de la face avant des structures avec la première face de couche support,
- un détachement, dit premier détachement, des structures du substrat initial.

Selon un mode de mise en œuvre, le premier détachement nécessite une énergie, dite première énergie de détachement, ajustée pour être inférieure à l'énergie d'adhésion entre la face avant des structures et la première face.

Selon un mode de mise en œuvre, la première énergie de détachement est inférieure à 0,5 J/m².

Selon un mode de mise en œuvre, I l'ajustement de la première énergie de détachement comprend une étape de fragilisation de l'interface entre la face initiale et la face arrière, avantageusement, l'étape de fragilisation comprend une réduction de la surface de contact entre la face initiale et la face arrière.

Selon un mode de mise en œuvre, l'étape c) comprend successivement :
- un assemblage des structures avec le substrat d'accueil par mise en contact desdites structures par leur face arrière avec la face d'accueil du substrat d'accueil,
- un détachement, dit second détachement, des structures de la première face de manière à transférer lesdites structures sur la face d'accueil.

Selon un mode de mise en œuvre, l'énergie d'adhésion des structures sur la première face est inférieure à l'énergie d'adhésion des structures sur la face d'accueil.

Selon un mode de mise en œuvre, le substrat d'accueil comprend sur sa face d'accueil des sites, dits sites d'accueil, sur lesquels sont reportées les structures, les sites d'accueil étant adaptés pour favoriser l'adhésion des structures sur lesdits sites d'accueil par rapport à l'adhésion desdites structure sur la première face.

Selon un mode de mise en œuvre, les sites d'accueil comprennent au moins un des éléments choisi parmi : billes de brasure, des micro tubes, des empilements métallique permettant une adhésion des structures sur la face d'accueil par collage eutectique, des matériaux magnétiques, une colle polymère.

L'invention concerne également un procédé de transfert des structures d'un premier type, d'un second type et d'un troisième type sur un substrat d'accueil, le procédé comprenant successivement le transfert, selon la présente invention, des structures du premier type, du second type et du troisième type sur le substrat d'accueil

Selon un mode de mise en œuvre, les structures du premier type, du second type et du troisième type sont des LED émettant chacune dans un domaine de longueur d'onde différent.

### BRÈVE DESCRIPTION DES DESSINS

D'autres caractéristiques et avantages apparaîtront dans la description qui va suivre d'un procédé de transfert selon l'invention, donnés à titre d'exemples non limitatifs, en référence aux dessins annexés dans lesquels :
- les figures la à 1c sont des représentations schématiques d'un procédé de transfert impliquant un substrat étirable connu de l'état de la technique ;
- les figures 2a et 2b sont des représentations schématiques, selon un plan de coupe de la couche support, perpendiculaire à la première face, de la transition d'un état déplié (figure 2a) vers un état plié (figure 2b) d'une région de pliage selon la présente invention ;
- les figures 3a à 3d sont des représentations schématiques, selon un plan de coupe de la couche support, perpendiculaire à la première face, des différentes étapes susceptibles d'être mises en œuvre pour la formation de la couche support selon la présente invention ;
- les figures 4a à 4f sont des représentations schématiques, selon un plan de coupe de la couche support, perpendiculaire à la première face, du procédé de transfert de structures sur un substrat d'accueil selon la présente invention ;
- la figure 5 est une représentation schématique d'une étape de fragilisation, de l'interface entre les structures et la face initiale, mise en œuvre pour le premier détachement ;
- les figures 6a et 6b sont des représentations schématiques, selon un plan de coupe de la couche support, perpendiculaire à la première face, du mécanisme de dépliage de la couche support ;
- les figures 7a et 7b sont des représentations schématiques, selon une vue de la première face, de la couche support déployée (figure 7a) et de la couche support pliée (figure 7b) ;

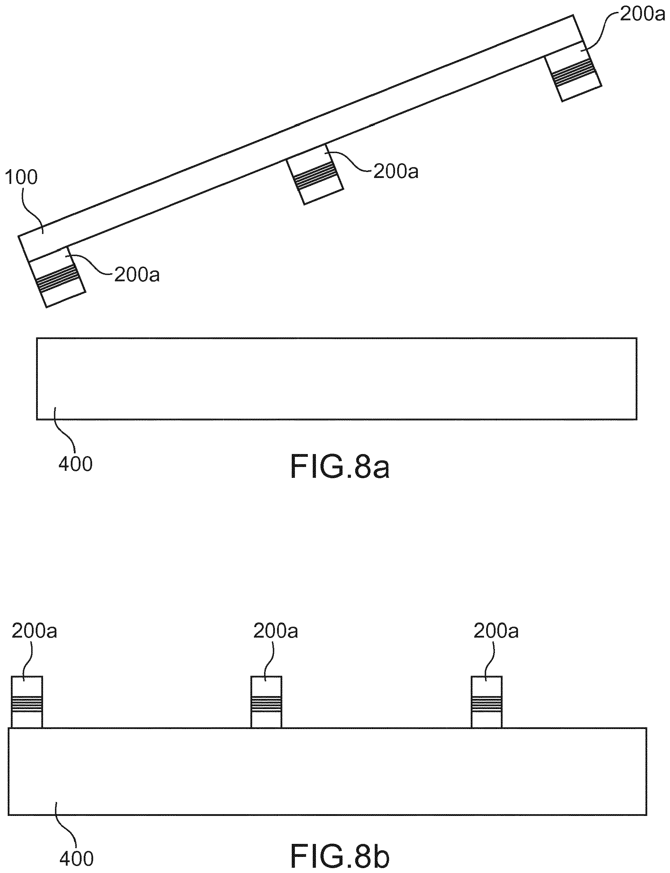

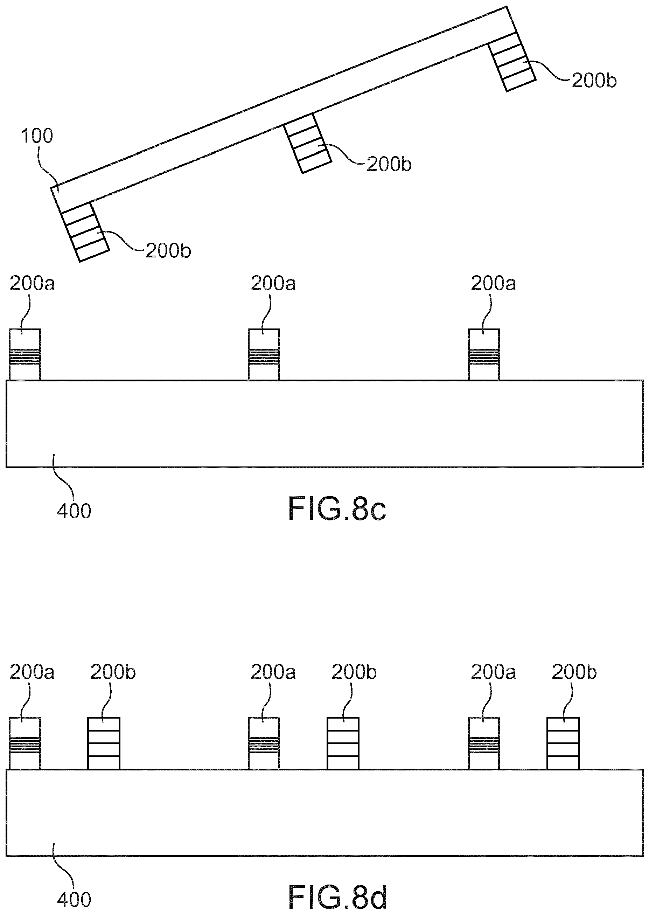

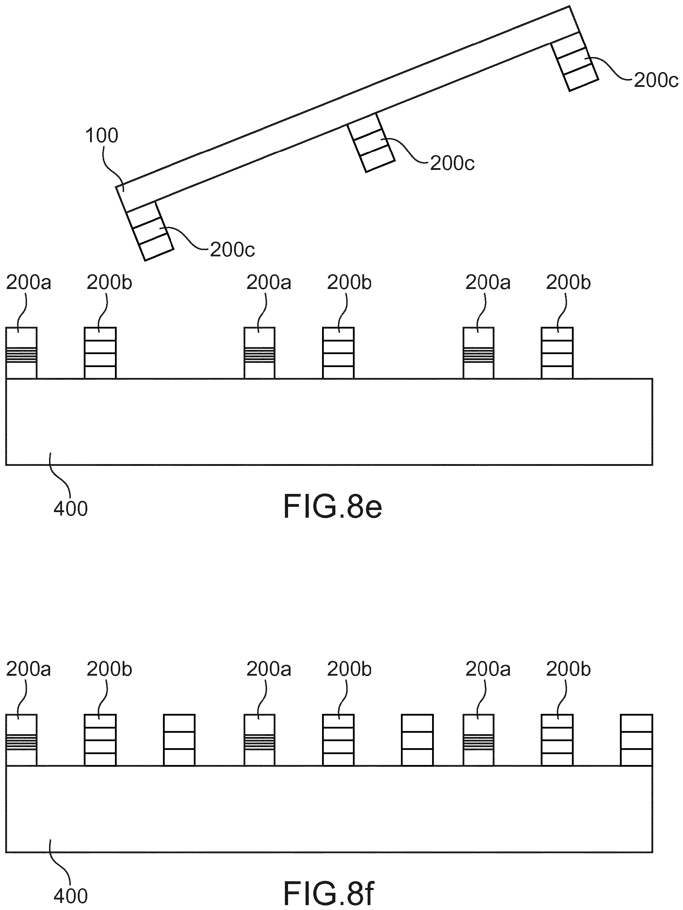

- les figures 8a à 8f sont des représentations schématiques des différentes étapes de transfert de LED de type différent, notamment pour la formation d'afficheurs.

### EXPOSÉ DÉTAILLÉ DE MODES DE RÉALISATION PARTICULIERS

La présente invention concerne un procédé de transfert de structures sur une face, dite face d'accueil, d'un substrat d'accueil.

En particulier, l'étape de transfert met en œuvre une couche support présentant des régions pliables et dépliables, avantageusement de manière réversible, permettant de faire varier l'espacement des structures avec leur transfert sur le substrat d'accueil.

Selon les termes de la présente invention, le pliage et le dépliage de la couche support est exécuté via l'action d'une excitation extérieure. En particulier, l'excitation extérieure permet un changement d'état de contrainte de la couche support générant ainsi les processus de pliage et de dépliage dans les régions de pliage.

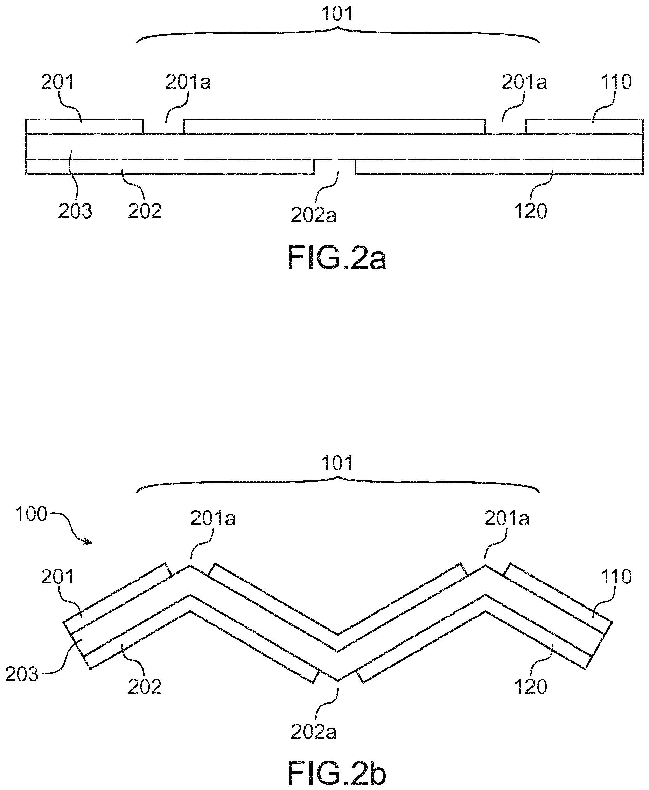

Les figures 2a-2b, 3a-3d, 4a-4f, 5, et 6a-6b illustrent, de façon schématique, les différentes étapes du procédé de transfert de structures selon la présente invention.

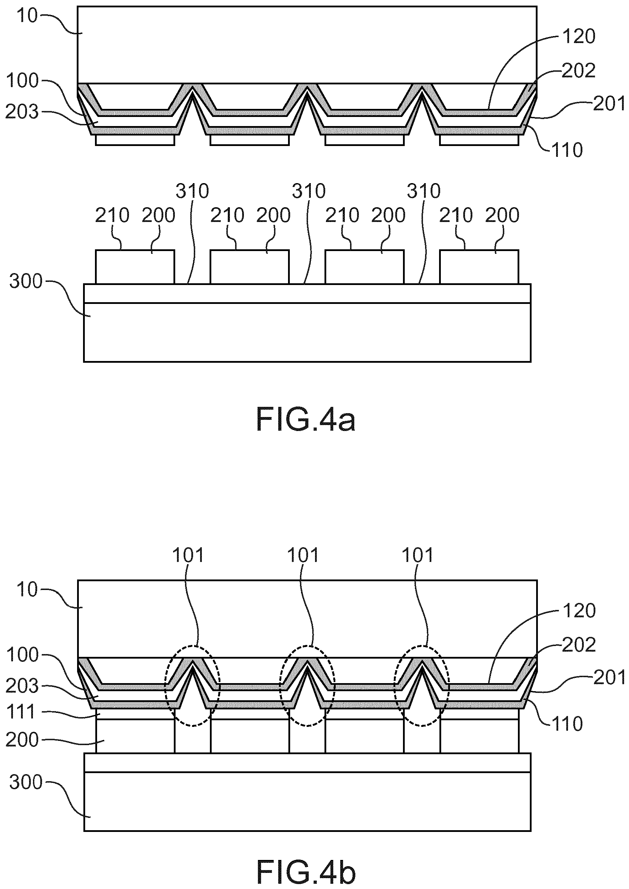

En particulier, le procédé selon la présente invention décrit dans la revendication 1, comprend une étape a) de fourniture d'une couche support 100 qui comprend deux faces principales, essentiellement parallèles, dites, respectivement, première face 110 et seconde face 120 (figures 2a et 4a).

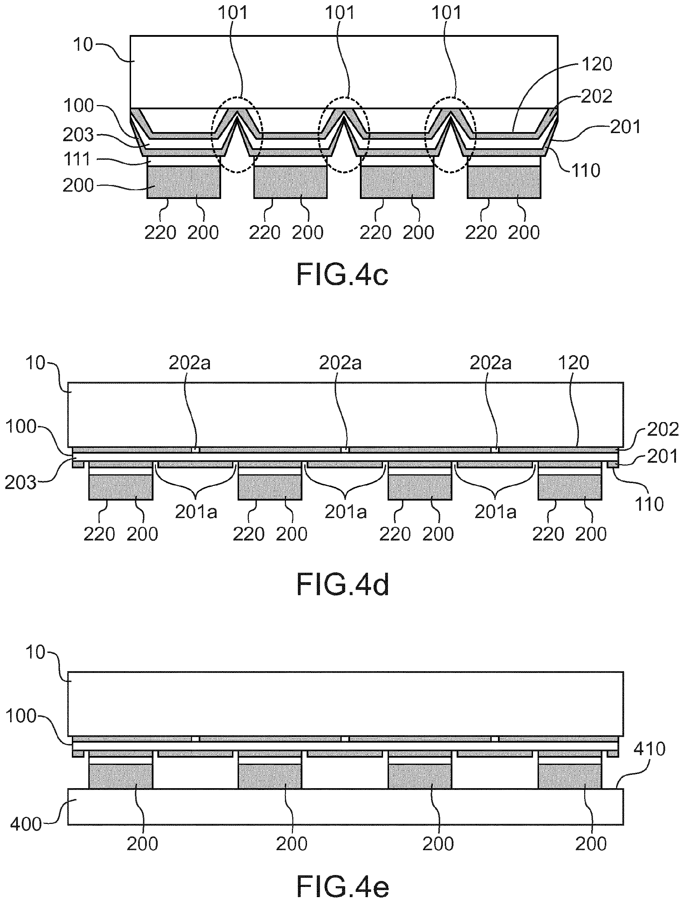

Des structures 200, comprenant chacune une face avant 210 et une face arrière 220, sont assemblées, selon leur face avant 210, sur la première face 110 de la couche support 100 (figure 4c).

Par « assemblées », on entend que les structures sont maintenues à la couche support par adhésion de leur face avant sur la première face de ladite couche support.

En particulier, le contact entre la face avant 210 et la première face 110 forme une interface dite interface de contact temporaire 111 (figure 4c).

La couche support 100 comprend des régions de pliage 101, entre les structures, adaptées pour passer, de manière réversible, d'un état plié à un état déplié sous l'action d'une excitation extérieure.

À cet égard les régions de pliage 101 peuvent être formées par des premiers chemins et des seconds chemins différents des premiers chemins, par exemple perpendiculaires aux premiers chemins.

Les régions de pliage 101 peuvent prendre différents types de formes. Notamment, les régions de pliage 101 peuvent représenter un quadrillage régulier ou non. De manière alternative ou complémentaire, les régions de pliage 101 peuvent être, au moins en partie, courbes. Le document [3] cité à la fin de la description récence différent type de régions de pliages susceptibles d'être mises en œuvre dans le cadre de la présente invention.

Par « état plié », on entend une région qui présente de plis en creux et des plis en arête.

Le passage d'un état plié à un état déplié permet alors de faire varier l'espacement entre les structures 200.

Le passage de l'état plié à l'état déplié est induit par l'action d'une excitation extérieure.

Selon l'invention, le passage de l'état plié à l'état déplié est réversible.

La couche support 100 comprend une couche intermédiaire 203 adaptée pour, sous l'action de l'excitation extérieure, faire varier son état de contrainte, et ainsi générer le passage de l'un ou l'autre des états plié et déplié à l'autre de ces deux états. En particulier, la couche support 100 comprend de sa première face 210 vers sa seconde face 220, une première couche 201, la couche intermédiaire 203, et une seconde couche 202. Notamment, la première couche 201 et la seconde couche 202, présentant, respectivement, des premières tranchées 201a et des secondes tranchées 202b au niveau desquelles s'inscrivent des plis dans les régions de pliage 101 lorsque la couche support 100 est dans l'état plié (figure 2b).

L'homme du métier pourra ajuster les largeurs des premières et des secondes tranchées, ainsi que les épaisseurs de la première couche 201, de la seconde couche 202 et de la couche intermédiaire 203 en fonction des angles de pliage requis.

En particulier, les largeurs des premières tranchées 201a et des secondes tranchées 202a peuvent être comprises entre 200nm et 30µm.

La première couche 201 et la seconde couche 202 peuvent présenter une épaisseur comprise entre 0,07 µm et 1 µm.

La couche intermédiaire 203 peut présenter une épaisseur comprise entre 1 µm et 6 µm.

Selon une première configuration, le passage d'un état déplié à un état plié peut correspondre à un changement d'état de contrainte de la couche intermédiaire associé à un gonflement de ladite couche.

Par « gonflement », on entend une expansion de la couche intermédiaire 203. Le gonflement, au sens de la présente invention, peut comprendre aussi bien l'établissement d'une contrainte en tension que l'absorption d'un liquide ou d'un gaz.

Ainsi, les figures 2a et 2b illustrent le passage d'un état déplié à un état plié de la couche support 100 sous l'action d'une excitation extérieure.

L'action de l'excitation extérieure sur la couche intermédiaire 203 provoque le gonflement de cette dernière, notamment à l'endroit même des premières tranchées 201a et des secondes tranchées 202a. L'expansion de la couche intermédiaire 203 au niveau des premières et secondes tranchées 201a et 202a induit la formation, sur la première face, de plis en arête et de plis en creux définis, respectivement, par les première tranchées 201a et par les secondes tranchées 202a.

Le retour à l'état déplié peut alors être exécuté selon un processus inverse, à savoir la contraction de la couche intermédiaire.

Selon une seconde configuration, le passage d'un état déplié à un état plié peut correspondre à un changement d'état de contrainte de la couche intermédiaire 203 associé à une contraction de ladite couche.

Par « contraction », on entend une réduction du volume de la couche intermédiaire 203.

L'action de l'excitation extérieure sur la couche intermédiaire 203 provoque la contraction de cette dernière, notamment à l'endroit même des premières tranchées 201a et des secondes tranchées 202a. La contraction de la couche intermédiaire 203 au niveau des premières et secondes tranchées 201a et 202a induit la formation, sur la première face, de plis en creux et de plis en arête définis, respectivement, par les première tranchées 201a et par les secondes tranchées 202a.

Quelle que soit la configuration considérée, la première couche 201 et la seconde couche 202 présentent chacune un module d'Young supérieur à celui de la couche intermédiaire, de manière à rigidifier la couche support 100.

De manière avantageuse, le module d'Young de la première couche 201 et de la seconde couche 202 est supérieur à 2 GPa, encore plus avantageusement égal à 4 GPa.

À titre d'exemple, la première couche 201 et la seconde couche 202 peuvent chacune comprendre du poly(p-methylstyrène) (ci-après « PpMS »).

La PpMS est avantageusement mis en œuvre avec de la benzophenone agissant comme photo-amorceur.

Les premières tranchées 201a et les secondes tranchées 202b, dans le cas spécifique du PpMS, peuvent être formées par une étape de photolithographie. Toutefois, la présente invention n'est pas limitée à la formation des tranchées par photolithographie, et toute autre technique, connue de l'homme du métier, et susceptible de convenir à la formation de tranchées, peut être mise en œuvre dans le cadre de la présente invention.

Concernant l'excitation extérieure, cette dernière peut prendre différentes formes. En particulier, et de manière non-limitative, l'excitation extérieure peut comprendre :
- une variation de pH ;
- l'adjonction d'un solvant, notamment de l'eau ou du méthanol ;
- une variation de température, notamment une élévation de température ;
- une impulsion électrique ;
- la mise œuvre d'un enzyme.

Si l'excitation extérieure comprend une variation de pH, la couche intermédiaire 203 peut avantageusement comprendre au moins un des éléments choisi parmi : Poly(4-vinyl pyridine)-polystryrène, Poly(2-hydroxyethyl methacrylate)-poly(acide methacrylique), Poly(acide methacrylique)-polyethylène glycol, Poly(N-isopropylacrylamide-co-acide acrylique)-polyethylène glycol), Poly(chlorure de methacryloxyethyl trimethylammonium)-or.

Si l'excitation extérieure comprend une adjonction de solvant, la couche intermédiaire 203 peut avantageusement comprendre au moins un des éléments choisi parmi : alcool polyvinylique- chitosane, chitosane polyéthylène glycol, polydiméthylsiloxane-polyurethane/2--hydroxyéthyl méthacrylate, poly(glycidyl méthacrylate)-or.

Si l'excitation extérieure comprend une variation de température, la couche intermédiaire 203 peut avantageusement comprendre au moins un des éléments choisi parmi : polydiméthylsiloxane-or, résine SU8-polycaprolactone, poly(N-isopropylacrylamide)-polycaprolactone, polycaprolactone, poly(caprolactone-co-pentadecadolactone).

Si l'excitation extérieure comprend une impulsion électrique, la couche intermédiaire peut avantageusement comprendre du polydiméthylsiloxane-cardiomyocytes ou du poly pyrrole-or.

Si l'excitation extérieure comprend la mise œuvre d'une enzyme, la couche intermédiaire 203 peut avantageusement comprendre du métal-gélatine-carboxyméthylcellulose.

De manière particulièrement avantageuse, la couche support 100 repose par sa seconde face 120 sur un substrat support 10. En particulier, l'énergie d'adhésion entre la seconde face 120 et le substrat support 10 est ajustée afin de permettre le passage de l'un ou l'autre des états plié et déplié à l'autre de ces deux états, avantageusement, l'énergie d'adhésion est inférieure à 0.3 J/m2. En d'autres termes, l'énergie d'adhésion entre la couche support 100 et le substrat support est ajustée pour conférer à ladite couche support la faculté de se plier et de se déplier. Cette fonction, ou ajustement de l'énergie d'adhésion peut être assurée par une couche, dite couche de relâchement 400, intercalée entre la couche support 100 et le substrat support 10.

De manière avantageuse, la couche de relâchement 400 comprend de l'acide polyacrylique (ci-après « PAA »).

Une couche de PAA peut présenter une épaisseur comprise entre 500nm et 5µm.

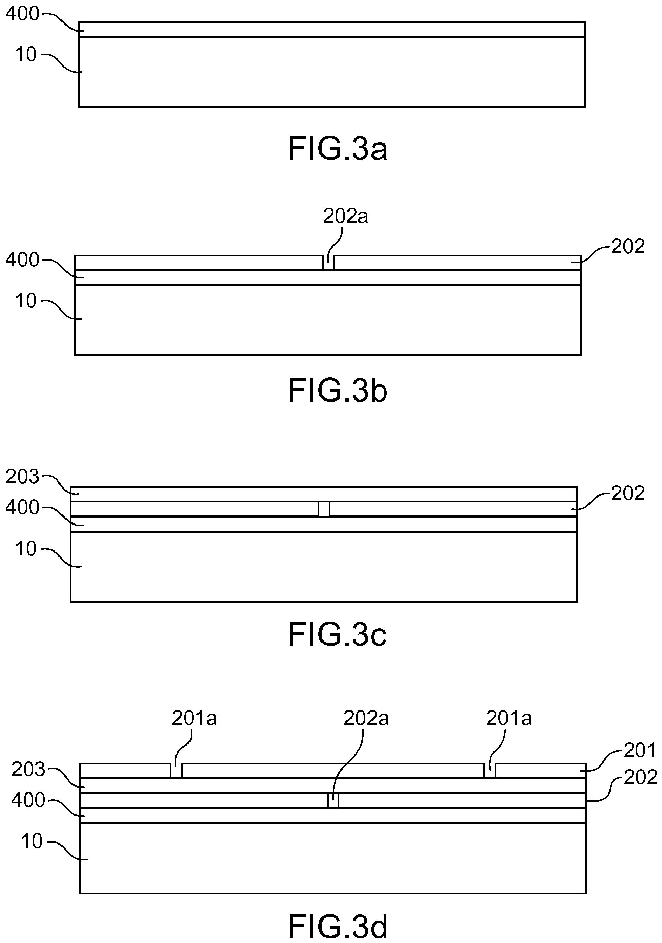

Un exemple particulier de réalisation de la couche support 100 sur un substrat support 10 est illustré aux figures 3a à 3d.

Cet exemple particulier comprend la fourniture d'un substrat support 10, par exemple un substrat fait d'un matériau semi-conducteur, notamment du silicium.

Une couche de relâchement 400 est alors formée sur une face principale du substrat support 10. Par exemple, la couche de relâchement 400 comprend du PAA avec une épaisseur 2 µm (figure 3a).

La formation de la seconde couche 202 (figure 3b) sur la couche de PAA est exécutée en répandant du PpMS à l'aide d'une tournette (« Spin Coating » selon la terminologie anglo-saxonne). Le PpMS contient par ailleurs un photo-amorceur, par exemple de la benzophénone, et est dilué dans du toluène selon une concentration massique comprise entre 10 mg/mL à 100 mg/mL, par exemple 50 mg/mL. La seconde couche 202 peut présenter une épaisseur comprise entre 0,07 µm et 5 µm, par exemple 0,5 µm.

La formation de la seconde couche 202 est alors suivie de la formation des secondes tranchées 202a (figure 3c), par exemple par une étape de photolithographie, et plus particulièrement par photolithographie UV, à une longueur d'onde de 365 nm.

Une couche intermédiaire 203, comprenant du poly(N-isopropyl acrylamide-co-acrylate de sodium) (ci-après « PNIPAM »), est ensuite formée sur la seconde couche 202. Le PNIPAM est dans un premiertemps répandu sur la seconde couche 202 à l'aide d'une tournette, et, dans un second temps, réticulé avec une dose de rayonnement UV de l'ordre de 10 J/cm². La couche intermédiaire de PNIPAM peut présenter une épaisseur comprise entre 1 µm et 1,5 µm ou entre 2 µm et 6 µm dépendamment des solvants et types de séchages mis en œuvre.

Enfin, la première couche 201 (figure 3d), avec ses premières tranchées 201a, est formée sur la couche intermédiaire 203 selon les mêmes modalités que la seconde couche 202.

Concernant les structures 200, ces dernières peuvent, au cours d'une étape a1) précédant l'étape a), avoir été prélevées, selon leur face arrière 220, d'une face initiale 310 d'un substrat initial 300 (figures 4a à 4c).

En particulier, l'étape de prélèvement a1) peut comprendre successivement :
1a1) un assemblage de la face avant 210 de chacune des structures 200 sur la première face 110 (figures 4a et 4b),
2a1) un détachement, dit premier détachement, des structures du substrat initial 300 (figure 4c).

L'étape 1a1) peut comprendre une étape de collage direct par la mise en contact de la première face 110 avec les faces avant 210.

Les structures peuvent être agencées de manière matricielle sur la face initiale, sans toutefois limiter la présente invention à cet agencement.

Par « agencées de manière matricielle », on entend un arrangement de structures régulier et périodique selon des directions X et Y différentes l'une de l'autre et comprises dans un plan défini par la face sur laquelle reposent lesdites structures.

Il est entendu que l'étape de prélèvement a1) ne modifie pas cet agencement matriciel des structures.

Il est également entendu que lors de l'étape de prélèvement, les structures 200 sont mises en contact avec la première face entre les régions de pliage.

L'étape 2a1), de premier détachement, peut nécessiter une énergie, dite première énergie de détachement, ajustée pour être inférieure à l'énergie d'adhésion entre la face avant 210 des structures 200 et la première face 110, dite énergie d'adhésion temporaire. Ainsi, cette hiérarchisation des énergies d'adhésions permet de prélever efficacement l'ensemble des structures 200.

La première énergie d'adhésion peut, par exemple, être ajustée par un choix approprié du matériau formant la face initiale.

De manière alternative ou complémentaire, la première énergie d'adhésion peut également être ajustée en fragilisant l'interface entre la face initiale 310 du substrat initial 300 et la face arrière 220 des structures 200.

Cette étape de fragilisation peut par exemple comprendre une réduction de la surface de contact entre la face arrière 220 des structures 200 et la face initiale 310 du substrat initial 300.

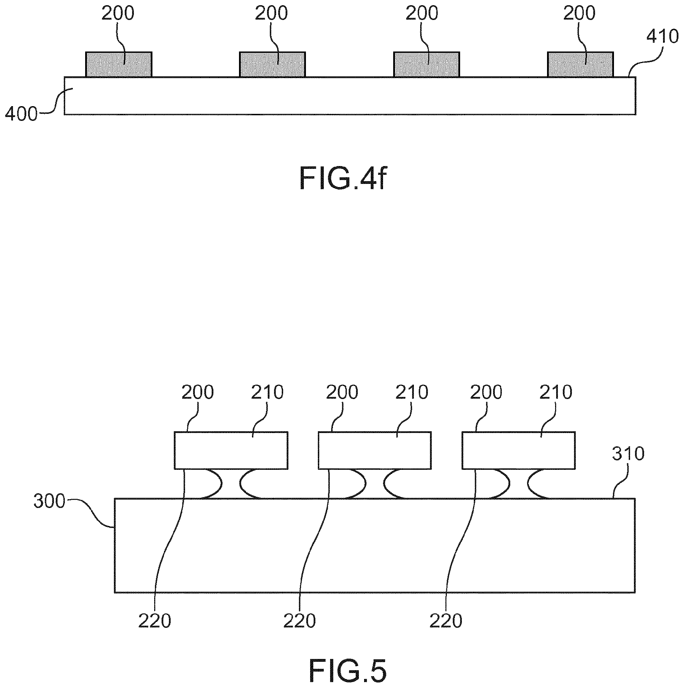

La réduction de surface peut être obtenue par une étape de gravure, notamment par voie liquide, au niveau de l'interface formée par la face arrière 220 et la face initiale 310. Notamment, l'étape de gravure peut comprendre un retrait partiel du matériau formant la face initiale 310 en contact avec la face arrière 220 (figure 5).

L'ajustement de la première énergie de détachement peut alors être exécuté de sorte que cette dernière soit inférieure à 0,3 J/m².

De manière complémentaire, l'énergie d'adhésion temporaire est avantageusement supérieure à 0,5 J/m².

L'étape a) peut alors être suivie d'une étape b) qui comprend l'application d'une action extérieure (« stimulus ») de manière à faire passer les régions de pliage de l'un ou l'autre des états plié ou déplié à l'autre des états plié ou déplié de sorte que l'espacement entre les structures varie (figure 4d).

Par exemple, à l'issue de l'étape a), la couche support 100 peut présenter des régions de pliage 101 dans un état plié. En d'autres termes, l'étape b) comprend l'application d'un stimulus pour déplier lesdites régions de pliage 101.

Selon cet exemple, l'espacement entre les structures 200 augmente lors de l'exécution de l'étape b).

Il est entendu que l'espacement entre les structures, et éventuellement l'agencement relatif desdites structures, varie en fonction de l'orientation des premières tranchées 201a et des secondes tranchées 202a.

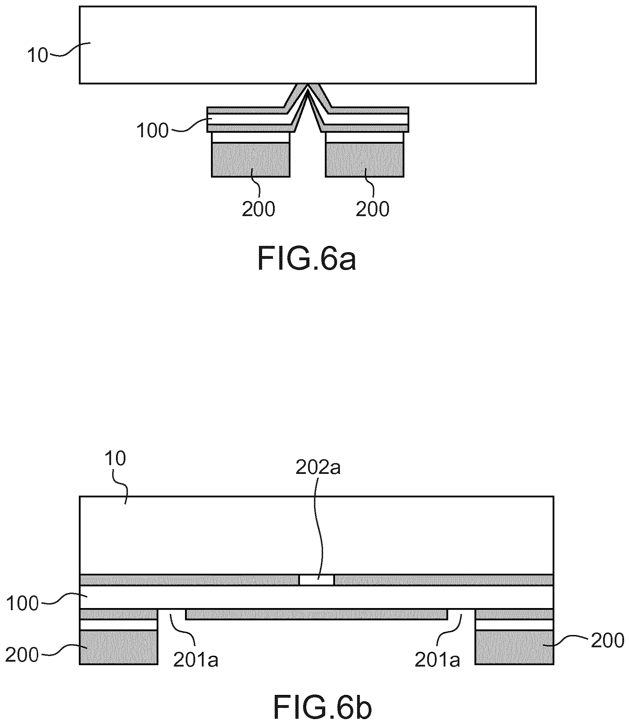

En particulier, les premières tranchées 201a et les secondes tranchées 202a peuvent être agencées de sorte que le déploiement de la couche support 100 à l'étape b) corresponde à une extension homothétique selon les directions X et Y définies par l'agencement matricielle des structures 200 (figures 6a et 6b). A cet égard, les premiers chemins peuvent comprendre des premières tranchées et des secondes tranchées parallèles auxdits premiers chemins. De manière équivalente, les seconds chemins peuvent également comprendre des premières tranchées et des secondes tranchées parallèles auxdits seconds chemins.

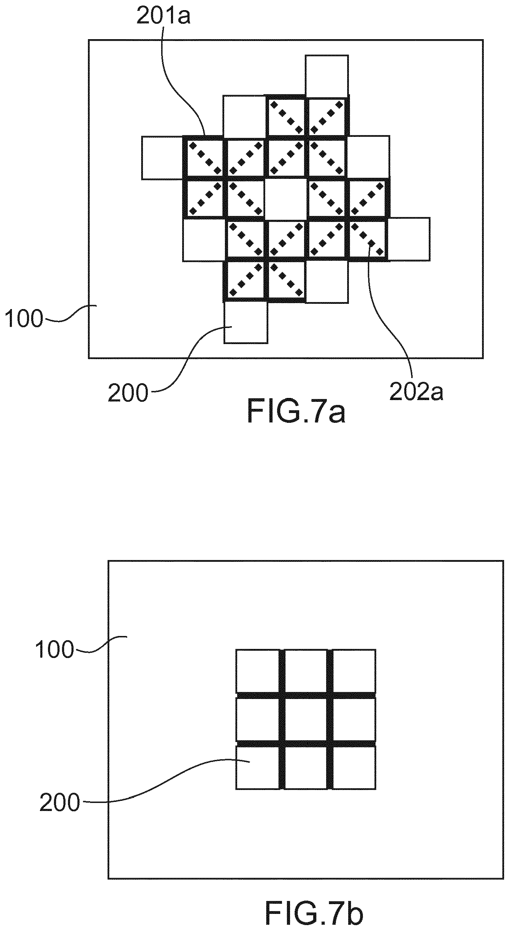

Il est également possible de modifier l'agencement relatif des structures 200 les unes par rapport aux autres par exemple en agençant les premières et secondes tranchées différemment. Les figures 7a et 7b illustrent un agencement dans lequel les premières tranchées (en traits pleins) et les secondes tranchées (en trait discontinus) forment chacune des croisillons distincts, et présentant un décalage angulaire de 45°.

L'étape b) est suivie d'une étape c) de report de la pluralité de structures sur une face d'accueil 410 d'un substrat d'accueil 400.

L'étape c) de report peut comprendre les étapes suivantes :
1c) un assemblage des structures 200 avec le substrat d'accueil 400 par mise en contact desdites structures 200 par leur face arrière 220 avec la face d'accueil 410 du substrat d'accueil 400 (figure 4e),
2c) un détachement, dit second détachement, des structures 200 de la première face 110 de manière à transférer lesdites structures 200 sur la face d'accueil 410 (figure 4f).

L'étape 1c) d'assemblage comprend avantageusement un collage par adhésion moléculaire (ou collage direct).

Par ailleurs, l'énergie d'adhésion entre les structures 200 et la face d'accueil 410, dite énergie d'adhésion d'accueil, est avantageusement supérieure à l'énergie d'adhésion temporaire. Par exemple l'énergie d'adhésion d'accueil peut être supérieure à 1 J/m².

L'étape 2c) peut être exécutée par fragilisation de l'interface de contact temporaire 111.

Cette fragilisation peut comprendre un effort consistant à décoller la couche support 100 des structures 200. L'effort peut être exercé par exemple en insérant une lame au niveau de l'interface de contact temporaire 111.

De manière avantageuse, le substrat d'accueil 400 comprend sur sa face d'accueil 410 des sites, dits sites d'accueil, sur lesquels sont reportées les structures 200, les sites d'accueil étant adaptés pour favoriser l'adhésion des structures sur lesdits sites d'accueil par rapport à l'adhésion desdites structure sur la première face.

Selon cette caractéristique avantageuse, l'ensemble des structures restent sur les sites d'accueil lors du détachement de la couche support 100.

Les sites d'accueil peuvent comprendre au moins des éléments choisi parmi : billes de brasure, des micro tubes, des empilements métallique permettant une adhésion des structures sur la face d'accueil par collage eutectique, des matériaux magnétiques, une colle polymère.

Les structures 200 peuvent comprendre tout type de cellule ou d'empilement de films. Notamment, les structures 200 peuvent comprendre au moins une des structures type choisie parmi : lentilles, réflecteurs, empilement de couches, des plots, des composant CMOS, des LEDs, des modules LED et CMOS tels que décrits dans la demande FR 1561421, des couches de conversions.

Le procédé peut avantageusement être mis en œuvre pour le report de différents types de structures sur un même substrat d'accueil.

Par exemple, un procédé non revendiqué ici peut être mis en œuvre pour le report de structures 200 d'un premier type, dites premières structures 200a, puis de structures d'un second type, dites secondes structures 200b, sur un même substrat d'accueil 400 (figures 7a à 7f).

Les premières structures 200a et les secondes structures 200b sont alors reportées sur la face d'accueil du substrat d'accueil, respectivement, selon un premier agencement et un second agencement.

Le premier et le second agencement peuvent être identiques, et décalés selon une direction comprise dans un plan formé par la face d'accueil.

Des structures 200 d'un troisième type, dites troisièmes structures 200c, peuvent également être reportées selon un troisième agencement identique au premier agencement et décalé des premier et second agencements selon une direction comprise dans un plan formé par la face d'accueil.

De manière particulièrement avantageuse, un procédé non revendiqué ici peut ainsi être mis en œuvre pour la formation d'afficheurs. Notamment, les premières, secondes et troisièmes structures comprennent, respectivement, des LED bleues, des LED vertes, et des LED rouges (par « LED » on entend une diode électroluminescente).

Une LED bleue est une LED émettant un rayonnement lumineux dans la gamme de longueurs d'ondes 300nm-500nm.

Une LED rouge est une LED émettant un rayonnement lumineux dans la gamme de longueurs d'ondes 600nm-700nm.

Une LED verte est une LED émettant un rayonnement lumineux dans la gamme de longueurs d'ondes 500nm-600nm.

### REFERENCE

[1] US 2016/111604 ;
[2] Jun-Hee et al., « Programming Reversibly Self-folding Origami with Micropatterned-Crosslinkable Polymer trilayers », Advanced Materials, 27, 79-85, 2015;
[3] Tomohiro Tachi, "Freeform Origami Tessellations by Generalizing Resch's Patterns", Proceedings of the ASME 2013 International Design Engineering Technical Conférence and Computers and Information in Engineering Conférence IDETC/CIE 2013; [4] US 2016/043254 A1.

## Revendications

1. Procédé de transfert de structures sur un substrat d'accueil (400), le procédé comprenant les étapes successives suivantes :
a) fournir une couche support (100) comprenant deux faces principales dites, respectivement, première face (110) et seconde face (120), des structures (200), comprenant chacune une face avant (210) et une face arrière (220), étant assemblées par leur face avant (210) sur la première face (110) ;
c) une étape de report des structures (200) sur une face d'accueil (410) d'un substrat d'accueil (400),
le procédé étant remarquable en ce que
la couche support (100) comprend des régions de pliage (101), entre les structures (200), adaptées pour passer, de manière réversible, d'un état plié à un état déplié sous l'action d'une excitation extérieure,
le procédé comprend en outre, entre les étapes a) et c), une étape b) d'exécution de l'action extérieure de manière à faire passer les régions de pliage (101) de l'un ou l'autre des états plié ou déplié à l'autre des états plié ou déplié de sorte que l'espacement entre les positions relatives des structures (200) les unes par rapport aux autres varie avant l'exécution de l'étape c),
la couche support (100) comprend en outre une couche intermédiaire (203) adaptée pour, sous l'action de l'excitation extérieure, faire varier son état de contrainte, et ainsi générer le passage de l'un ou l'autre des états plié et déplié à l'autre de ces deux états, la couche support (100) comprend de sa première face (110) vers sa seconde face (120), une première couche (201), la couche intermédiaire (203), et une seconde couche (202), la première couche (201) et la seconde couche (202), présentant, respectivement, des premières tranchées (201a) et des secondes tranchées (202b) au niveau desquelles s'inscrivent des plis au niveau des régions de pliage (101) lorsque la couche support (100) est dans l'état plié.

2. Procédé selon la revendication 1, dans lequel lors du passage d'un état déplié à un état plié, le changement d'état de contrainte de la couche intermédiaire (203) correspond à un gonflement de ladite couche de sorte que les premières tranchées (201a) et les secondes tranchées (202b) définissent sur la première face (110), dans l'état plié, respectivement, des plis en arrête et des plis en creux.

3. Procédé selon la revendication 1, dans lequel lors du passage d'un état déplié à un état plié, le changement d'état de contrainte de la couche intermédiaire (203) correspond à une contraction de ladite couche de sorte que les premières tranchées (201a) et les secondes tranchées (202b) définissent sur la première face (110), dans l'état plié, respectivement, des plis en creux et des plis en arrête.

4. Procédé selon l'une des revendications 1 à 3, dans lequel la première couche (201) et la seconde couche (202) présentent chacune un module d'Young supérieur à celui de la couche intermédiaire (203), avantageusement le module d'Young de la première couche (201) et de la seconde couche (202) est supérieur à 2 GPa, encore plus avantageusement égal à 4 GPa.

5. Procédé selon l'une des revendications 1 à 4, dans lequel la première couche (201) et la seconde couche (202) comprennent du poly(p-methylstyrène).

6. Procédé selon l'une des revendication 1 à 5, dans lequel l'excitation extérieure est une variation de pH.

7. Procédé selon la revendication 6, dans lequel la couche intermédiaire (203) comprend au moins un des éléments choisi parmi : Poly(4-vinyl pyridine)-polystryrène, Poly(2-hydroxyethyl methacrylate)-poly(acide methacrylique), Poly(acide methacrylique)-polyethylène glycol, Poly(N-isopropylacrylamide-co-acide acrylique)-polyethylène glycol), Poly(chlorure de methacryloxyethyl trimethylammonium)-or.

8. Procédé selon l'une des revendications 1 à 5, dans lequel l'excitation extérieure comprend l'adjonction d'un solvant, notamment de l'eau ou du méthanol.

9. Procédé selon la revendication 8, dans lequel la couche intermédiaire (203) comprend au moins un des éléments choisi parmi : alcool polyvinylique- chitosane, chitosane polyéthylène glycol, polydiméthylsiloxane-polyurethane/2--hydroxyéthyl méthacrylate, poly(glycidyl méthacrylate)-or.

10. Procédé selon l'une des revendications 1 à 5, dans lequel l'excitation extérieure comprend une variation de température, notamment une élévation de température.

11. Procédé selon la revendication 10, dans lequel la couche intermédiaire (203) comprend au moins un des éléments choisi parmi : polydiméthylsiloxane-or, résine SU8-polycaprolactone, poly(N-isopropylacrylamide)-polycaprolactone, polycaprolactone, poly(caprolactone-co-pentadecadolactone).

12. Procédé selon l'une des revendications 1 à 5, dans lequel l'excitation extérieure comprend une impulsion électrique, la couche intermédiaire (203) comprenant avantageusement du polydiméthylsiloxane-cardiomyocytes ou du poly pyrrole-or.

13. Procédé selon l'une des revendications 1 à 5, dans lequel l'excitation extérieure comprend la mise œuvre d'un enzyme, la couche intermédiaire (203) comprenant avantageusement du métal-gélatine-carboxyméthylcellulose.

14. Procédé selon l'une des revendications 1 à 13, dans lequel la couche support (100) repose par sa seconde face (120) sur un substrat support, l'énergie d'adhésion entre la seconde face (120) et le substrat support étant ajustée afin de permettre la passage de l'un ou l'autre des états plié et déplié à l'autre de ces deux états, avantageusement, l'énergie d'adhésion est inférieure à 0,5 J/m², encore plus avantageusement inférieure à 0,3 J/m².

15. Procédé selon la revendication 14, dans lequel une couche, dite couche de relâchement, est intercalée entre la couche support (100) et le substrat support, la couche de relâchement comprenant avantageusement un acide polyacrylique.

16. Procédé selon l'une des revendications 1 à 15, dans lequel de l'étape a) est précédée d'une étape de prélèvement a1) des structures (200) disposées selon leur face arrière (220), sur une face, dite face initiale (310), d'un substrat initial (300).

17. Procédé selon la revendication 16, dans lequel l'étape de prélèvement a1) comprend successivement :
- un assemblage de la face avant (210) des structures (200) avec la première face (110) de couche support (100),
- un détachement, dit premier détachement, des structures (200) du substrat initial (300).

18. Procédé selon la revendication 17, dans lequel le premier détachement nécessite une énergie, dite première énergie de détachement, ajustée pour être inférieure à l'énergie d'adhésion entre la face avant (210) des structures (200) et la première face (110).

19. Procédé selon la revendication 18, dans lequel la première énergie de détachement est inférieure à 0,5 J/m².

20. Procédé selon la revendication 18 ou 19, dans lequel l'ajustement de la première énergie de détachement comprend une étape de fragilisation de l'interface entre la face initiale (310) et la face arrière (220), l'étape de fragilisation comprenant avantageusement une réduction de la surface de contact entre la face initiale (310) et la face arrière (220).

21. Procédé selon l'une des revendications 1 à 20, dans lequel l'étape c) comprend successivement :
- un assemblage des structures (200) avec le substrat d'accueil (400) par mise en contact desdites structures (200) par leur face arrière (220) avec la face d'accueil (410) du substrat d'accueil (400),
- un détachement, dit second détachement, des structures (200) de la première face (110) de manière à transférer lesdites structures (200) sur la face d'accueil (410).

22. Procédé selon la revendication 20 ou 21, dans lequel l'énergie d'adhésion des structures (200) sur la première face (110) est inférieure à l'énergie d'adhésion des structures (200) sur la face d'accueil (410).

23. Procédé selon l'une des revendications 1 à 22, dans lequel le substrat d'accueil (400) comprend sur sa face d'accueil (410) des sites, dits sites d'accueil, sur lesquels sont reportées les structures (200), les sites d'accueil étant adaptés pour favoriser l'adhésion des structures (200) sur lesdits sites d'accueil par rapport à l'adhésion desdites structure sur la première face (110).

24. Procédé selon la revendication 23, dans lequel les sites d'accueil comprennent au moins un des éléments choisi parmi : billes de brasure, des micro tubes, des empilements métallique permettant une adhésion des structures (200) sur la face d'accueil (410) par collage eutectique, des matériaux magnétiques, une colle polymère.

25. Procédé de transfert des structures (200) d'un premier type, d'un second type et d'un troisième type sur un substrat d'accueil (400), le procédé comprenant successivement le transfert, selon l'une des revendications 1 à 24 des structures (200) du premier type, du second type et du troisième type sur le substrat d'accueil (400)

26. Procédé selon la revendication 25, dans lequel les structures (200) du premier type, du second type et du troisième type sont des LED émettant chacune dans un domaine de longueur d'onde différent.

## Patentansprüche

1. Verfahren zum Übertragen von Strukturen auf ein Aufnahmesubstrat (400), wobei das Verfahren die nachstehenden, aufeinanderfolgenden Schritte umfasst:
a) Bereitstellen einer Trägerschicht (100), die zwei Hauptflächen, erste Fläche (110) bzw. zweite Fläche (120) genannt, aufweist, wobei Strukturen (200), die jeweils eine Vorderseite (210) und eine Rückseite (220) aufweisen, mit ihrer Vorderseite (210) an der ersten Fläche (110) angebracht sind;
c) einen Schritt des Verlagerns der Strukturen (200) auf eine Aufnahmefläche (410) eines Aufnahmesubstrats (400),
wobei das Verfahren **dadurch gekennzeichnet ist, dass**
die Trägerschicht (100) zwischen den Strukturen (200) Faltungsbereiche (101) aufweist, die dazu geeignet sind, auf reversible Weise unter der Wirkung einer Anregung von außen von einem gefalteten Zustand in einen ungefalteten Zustand übergehen,
wobei das Verfahren ferner zwischen den Schritten a) und c) einen Schritt b) der Durchführung der Einwirkung von außen umfasst, um die Faltungsbereiche (101) von einem aus gefaltetem oder ungefaltetem Zustand in den anderen aus gefaltetem oder ungefaltetem Zustand zu bringen, so dass der Abstand zwischen den relativen Positionen der Strukturen (200) in Bezug zueinander vor der Ausführung von Schritt c) variiert,
wobei die Trägerschicht (100) ferner eine Zwischenschicht (203) aufweist, die dazu geeignet ist, unter der Wirkung der Anregung von außen ihren Spannungszustand zu verändern und so den Übergang von dem einen oder anderen aus gefaltetem und ungefaltetem Zustand in den anderen dieser beiden Zustände zu erzeugen, wobei die Trägerschicht (100) von ihrer ersten Fläche (110) zu ihrer zweiten Fläche (120) hin eine erste Schicht (201), die Zwischenschicht (203), und eine zweite Schicht (202) aufweist, wobei die erste Schicht (201) und die zweite Schicht (202) jeweils erste Gräben (201a) bzw. zweite Gräben (202b) aufweisen, an denen sich Faltungen an den Faltungsbereichen (101) abzeichnen, wenn sich die Trägerschicht (100) im gefalteten Zustand befindet.

2. Verfahren nach Anspruch 1, wobei beim Übergang von einem ungefalteten Zustand in einen gefalteten Zustand die Änderung des Spannungszustandes der Zwischenschicht (203) einem Aufquellen der Schicht entspricht, so dass die ersten Gräben (201a) und die zweiten Gräben (202b) auf der ersten Fläche (110) im gefalteten Zustand jeweils Faltenkämme bzw. Faltentäler definieren.

3. Verfahren nach Anspruch 1, wobei beim Übergang von einem ungefalteten Zustand in einen gefalteten Zustand die Änderung des Spannungszustandes der Zwischenschicht (203) einem Zusammenziehen der Schicht entspricht, so dass die ersten Gräben (201a) und die zweiten Gräben (202b) auf der ersten Fläche (110) im gefalteten Zustand Faltentäler bzw. Faltenkämme definieren.

4. Verfahren nach einem der Ansprüche 1 bis 3, wobei die erste Schicht (201) und die zweite Schicht (202) jeweils einen höheren Elastizitätsmodul als die Zwischenschicht (203) aufweisen, wobei vorteilhafterweise der Elastizitätsmodul der ersten Schicht (201) und der zweiten Schicht (202) größer als 2 GPa, noch vorteilhafter gleich 4 GPa, ist.

5. Verfahren nach einem der Ansprüche 1 bis 4, wobei die erste Schicht (201) und die zweite Schicht (202) Poly(p-methylstyrol) enthalten.

6. Verfahren nach einem der Ansprüche 1 bis 5, wobei die Anregung von außen eine pH-Änderung ist.

7. Verfahren nach Anspruch 6, wobei die Zwischenschicht (203) zumindest eines der Elemente enthält, die ausgewählt sind aus: Poly(4-Vinylpyridin)-Polystyrol, Poly(2-Hydroxyethylmethacrylat)-Poly(methacrylsäure), Poly(Methacrylsäure)-Polyethylenglykol, Poly(N-Isopropylacrylamid-co-acrylsäure)-Polyethylenglykol), Poly(Methacryloxyethyltrimethylammoniumchlorid)-Gold.

8. Verfahren nach einem der Ansprüche 1 bis 5, wobei die Anregung von außen die Zugabe eines Lösungsmittels, insbesondere Wasser oder Methanol, umfasst.

9. Verfahren nach Anspruch 8, wobei die Zwischenschicht (203) zumindest eines der Elemente enthält, die ausgewählt sind aus: Polyvinylalkohol-Chitosan, Chitosan-Polyethylenglykol, Polydimethylsiloxan-Polyurethan/2-hydroxyethylmethacrylat, Poly(glycidylmethacrylat)-Gold.

10. Verfahren nach einem der Ansprüche 1 bis 5, wobei die Anregung von außen eine Temperaturänderung, insbesondere einen Temperaturanstieg, umfasst.

11. Verfahren nach Anspruch 10, wobei die Zwischenschicht (203) zumindest eines der Elemente enthält, die ausgewählt sind aus: Polydimethylsiloxan-Gold, SU8-Polycaprolactonharz, Poly(N-isopropylacrylamid)-Polycaprolacton, Polycaprolacton, Poly(Caprolacton-co-pentadecadolacton).

12. Verfahren nach einem der Ansprüche 1 bis 5, wobei die Erregung von außen einen elektrischen Impuls umfasst, wobei die Zwischenschicht (203) vorteilhafterweise Polydimethylsiloxan-Kardiomyozyten oder Poly-Pyrrol-Gold enthält.

13. Verfahren nach einem der Ansprüche 1 bis 5, wobei die Anregung von außen die Verwendung eines Enzyms umfasst, wobei die Zwischenschicht (203) vorteilhafterweise Metall-Gelatine-Carboxymethylcellulose enthält.

14. Verfahren nach einem der Ansprüche 1 bis 13, wobei die Trägerschicht (100) mit ihrer zweiten Fläche (120) auf einem Trägersubstrat aufliegt, wobei die Adhäsionsenergie zwischen der zweiten Fläche (120) und dem Trägersubstrat so abgestimmt ist, dass der Übergang von dem einen oder anderen aus gefaltetem und ungefaltetem Zustand in den anderen dieser beiden Zustände ermöglicht wird, wobei die Adhäsionsenergie vorteilhafterweise weniger als 0,5 J/m², noch vorteilhafter weniger als 0,3 J/m², beträgt.

15. Verfahren nach Anspruch 14, wobei zwischen der Trägerschicht (100) und dem Trägersubstrat eine Schicht, Trennschicht genannt, eingefügt ist, wobei die Trennschicht vorteilhafterweise Polyacrylsäure enthält.

16. Verfahren nach einem der Ansprüche 1 bis 15, wobei dem Schritt a) ein Schritt a1) vorausgeht, bei dem Strukturen (200), die mit ihrer Rückseite (220) auf einer Seite eines Ausgangssubstrats (300), Ausgangsseite (310) genannt, angeordnet sind, entfernt werden.

17. Verfahren nach Anspruch 16, wobei der Entfernungsschritt a1) aufeinanderfolgend umfasst:
- Zusammenfügen der Vorderseite (210) der Strukturen (200) mit der ersten Fläche (110) der Trägerschicht (100),
- Ablösen der Strukturen (200) vom Ausgangssubstrat (300), erstes Ablösen genannt.

18. Verfahren nach Anspruch 17, wobei das erste Ablösen eine Energie, erste Ablösungsenergie genannt, erfordert, die so abgestimmt ist, dass sie geringer ist als die Adhäsionsenergie zwischen der Vorderseite (210) der Strukturen (200) und der ersten Fläche (110).

19. Verfahren nach Anspruch 18, wobei die erste Ablösungsenergie weniger als 0,5 J/m² beträgt.

20. Verfahren nach Anspruch 18 oder 19, wobei das Abstimmen der ersten Ablösungssenergie einen Schritt des Versprödens der Grenzfläche zwischen der Ausgangsseite (310) und der Rückseite (220) umfasst, wobei der Versprödungsschritt vorteilhafterweise eine Verringerung der Kontaktfläche zwischen der Ausgangsseite (310) und der Rückseite (220) umfasst.

21. Verfahren nach einem der Ansprüche 1 bis 20, wobei Schritt c) nacheinander umfasst:
- Zusammenfügen der Strukturen (200) mit dem Aufnahmesubstrat (400) durch Inkontaktbringen der Strukturen (200) an ihrer Rückseite (220) mit der Aufnahmefläche (410) des Aufnahmesubstrats (400),
- Ablösen der Strukturen (200) von der ersten Fläche (110), zweites Ablösen genannt, um die Strukturen (200) auf die Aufnahmefläche (410) zu übertragen.

22. Verfahren nach Anspruch 20 oder 21, wobei die Adhäsionsenergie der Strukturen (200) an der ersten Fläche (110) geringer ist als die Adhäsionsenergie der Strukturen (200) an der Aufnahmefläche (410).

23. Verfahren nach einem der Ansprüche 1 bis 22, wobei das Aufnahmesubstrat (400) an seiner Aufnahmefläche (410) Stellen, Aufnahmestellen genannt, aufweist, auf die die Strukturen (200) verlagert werden, wobei die Aufnahmestellen dazu geeignet sind, die Haftung der Strukturen (200) an den Aufnahmestellen in Bezug auf die Haftung der Strukturen an der ersten Fläche (110) begünstigen.

24. Verfahren nach Anspruch 23, wobei die Aufnahmestellen zumindest eines der Elemente enthalten, die ausgewählt sind aus: Lotkügelchen, Mikroröhrchen, Metallstapelungen, die die Haftung der Strukturen (200) an der Aufnahmefläche (410) durch eutektische Bindung, magnetische Materialien, Polymerklebstoff ermöglichen.

25. Verfahren zum Übertragen von Strukturen (200) eines ersten Typs, eines zweiten Typs und eines dritten Typs auf ein Aufnahmesubstrat (400), wobei das Verfahren die aufeinanderfolgende Übertragung der Strukturen (200) des ersten Typs, des zweiten Typs und des dritten Typs auf das Aufnahmesubstrat (400) nach einem der Ansprüche 1 bis 24 umfasst.

26. Verfahren nach Anspruch 25, wobei die Strukturen (200) des ersten Typs, des zweiten Typs und des dritten Typs LEDs sind, die jeweils in einer anderen Wellenlängendomäne emittieren.

## Claims

1. Method for transferring structures onto a host substrate (400), the method comprising the following successive steps:
a) supplying a support layer (100) comprising two main faces called, respectively, first face (110) and second face (120), structures (200), each comprising a front face (210) and a rear face (220), being assembled by their front face (210) on the first face (110);
c) a step of transferring the structures (200) onto a host face (410) of a host substrate (400),
the method being remarkable in that:
the support layer (100) comprises folding regions (101), between the structures (200), adapted to pass, in a reversible manner, from a folded state to an unfolded state under the action of an external excitation,
the method further comprises, between steps a) and c), a step b) of executing the external action in such a way as to make the folding regions (101) pass from one or the other of the folded or unfolded states to the other of the folded or unfolded states such that the spacing between the relative positions of the structures (200) with respect to each other varies before the execution of step c),
the support layer (100) further comprises an intermediate layer (203) adapted, under the action of the external excitation, to vary its stress state, and thereby generate the passage from one or the other of the folded and unfolded states to the other of these two states, the support layer (100) comprises from its first face (110) to its second face (120), a first layer (201), the intermediate layer (203), and a second layer (202), the first layer (201) and the second layer (202), having, respectively, first trenches (201a) and second trenches (202b) at the level of which are inscribed folds at the level of the folding regions (101) when the support layer (100) is in the folded state.

2. Method according to claim 1, wherein during the passage from an unfolded state to a folded state, the change of stress state of the intermediate layer (203) corresponds to a swelling of said layer such that the first trenches (201a) and the second trenches (202b) define on the first face (110), in the folded state, respectively, edge folds and hollow folds.

3. Method according to claim 1, wherein during the passage from an unfolded state to a folded state, the change of stress state of the intermediate layer (203) corresponds to a contraction of said layer such that the first trenches (201a) and the second trenches (202b) define on the first face (110), in the folded state, respectively, hollow folds and edge folds.

4. Method according to one of claims 1 to 3, wherein the first layer (201) and the second layer (202) each have a Young's modulus greater than that of the intermediate layer (203).

5. Method according to one of claims 1 to 4, wherein the first layer (201) and the second layer (202) comprise poly(p-methylstyrene).

6. Method according to one of claims 1 to 5, wherein the external excitation is a variation in pH.

7. Method according to claim 6, wherein the intermediate layer (203) comprises at least one of the elements selected from: poly(4-vinyl pyridine)-polystyrene, poly(2-hydroxyethyl methacrylate)-poly(methacrylic acid), poly(methacrylic acid)-polyethylene glycol, poly(N-isopropylacrylamide-co-acrylic acid)-polyethylene glycol), gold-poly(methacryl oxyethyl trimethylammonium chloride).

8. Method according to one of claims 1 to 5, wherein the external excitation comprises the addition of a solvent.

9. Method according to claim 8, wherein the intermediate layer (203) comprises at least one of the elements selected from: polyvinyl alcohol-chitosan, chitosan polyethylene glycol, polydimethylsiloxane-polyurethane/2-hydroxyethyl methacrylate, gold-poly(glycidyl methacrylate).

10. Method according to one of claims 1 to 5, wherein the external excitation comprises a variation in temperature, notably a rise in temperature.

11. Method according to claim 10, wherein the intermediate layer (203) comprises at least one of the elements selected from: gold-polydimethylsiloxane, SU8-polycaprolactone resin, poly(N-isopropylacrylamide)-polycaprolactone, polycaprolactone, poly(caprolactone-co-pentadecadolactone).

12. Method according to one of claims 1 to 5, wherein the external excitation comprises an electric pulse, the intermediate layer (203) comprising polydimethylsiloxane-cardiomyocytes or gold-poly pyrrole.

13. Method according to one of claims 1 to 5, wherein the external excitation comprises the implementation of an enzyme, the intermediate layer (203) advantageously comprises metal-gelatine-carboxymethylcellulose.

14. Method according to one of claims 1 to 13, wherein the support layer (100) rests by its second face (120) on a support substrate, the adhesion energy between the second face (120) and the support substrate being adjusted in order to enable the passage from one or the other of the folded and unfolded states to the other of these two states, advantageously, the adhesion energy is less than 0.5 J/m², even more advantageously less than 0.3 J/m².

15. Method according to claim 14, wherein a layer, called relaxation layer, is intercalated between the support layer (100) and the support substrate, the relaxation layer advantageously comprises a polyacrylique acid.

16. Method according to one of claims 1 to 15, wherein step a) is preceded by a step of removal a1) of the structures (200) arranged along their rear face (220), on a face, called initial face (310), of an initial substrate (300).

17. Method according to claim 16, wherein the step of removal a1) successively comprises:
- an assembly of the front face (210) of the structures (200) with the first face (110) of the support layer (100),
- a detachment, called first detachment, of the structures (200) from the initial substrate (300).

18. Method according to claim 17, wherein the first detachment requires an energy, called first detachment energy, adjusted to be less than the adhesion energy between the front face (210) of the structures (200) and the first face (110).

19. Method according to claim 18, wherein the first detachment energy is less than 0.5 J/m².

20. Method according to claim 18 or 19, wherein the adjustment of the first detachment energy comprises a step of weakening the interface between the initial face (310) and the rear face (220), the step of weakening advantageously, a reduction of the contact surface between the initial face (310) and the rear face (220).

21. Method according to one of claims 1 to 20, wherein step c) successively comprises:
- an assembly of the structures (200) with the host substrate (400) by placing in contact said structures (200) by their rear face (220) with the host face (410) of the host substrate (400),
- a detachment, called second detachment, of the structures (200) from the first face (110) in such a way as to transfer said structures (200) onto the host face (410).

22. Method according to claim 20 or 21, wherein the adhesion energy of the structures (200) on the first face (110) is less than the adhesion energy of the structures (200) on the host face (410).

23. Method according to one of claims 1 to 22, wherein the host substrate (400) comprises on its host face (410) sites, called host sites, onto which are transferred the structures (200), the host sites being adapted to favour the adhesion of the structures (200) on said host sites compared to the adhesion of said structures on the first face (110).

24. Method according to claim 23, wherein the host sites comprise at least one of the elements selected from: solder balls, micro tubes, metal stacks enabling adhesion of the structures (200) on the host face (410) by eutectic bonding, magnetic materials, a polymer adhesive.

25. Method for transferring structures (200) of a first type, of a second type and of a third type onto a host substrate (400), the method successively comprising the transfer, according to one of claims 1 to 24, of structures (200) of the first type, of the second type and of the third type onto the host substrate (400)

26. Method according to claim 25, wherein the structures (200) of the first type, of the second type and of the third type are LEDs each emitting in a different wavelength domain.
